# EUROPEAN PATENT APPLICATION

(11) **EP 4 607 652 A1**
(43) Date of publication of application: **27.08.2025**
(21) Application number: 22965525.3
(22) Date of filing: 17.11.2022
(51) Int. Cl.: H01M 10/635

(54) **HEAT DISSIPATION APPARATUS, VEHICLE, AND HEAT DISSIPATION CONTROL METHOD**

(71) Applicant: Shenzhen Yinwang Intelligent Technologies Co., Ltd., Shenzhen, Guangdong 518129 (CN)
(72) Inventor: PENG, Yaofeng, Shenzhen, Guangdong 518129 (CN)
(74) Representative: Thun, Clemens
(86) International application number: PCT/CN2022/132576
(87) International publication number: WO 2024/103342

(57) **Abstract**

A heat dissipation apparatus, a vehicle, and a heat dissipation control method are disclosed. The heat dissipation apparatus includes a housing and an air cooling part. The housing includes a first plate body, an intelligent module close to the first plate body is disposed in the housing, and the air cooling part and the intelligent module are disposed on a same side of the first plate body. The first plate body has a first cavity inside, the first plate body is located in a plurality of liquid cooling loops, and the air cooling part and/or the first plate body are/is configured to dissipate heat for the intelligent module. According to the foregoing solution, the heat dissipation apparatus may dissipate heat for the intelligent module in a liquid cooling heat dissipation mode or a heat dissipation mode combining air cooling and liquid cooling, and has a strong heat dissipation capability. Therefore, a heat dissipation effect on the intelligent module can be enhanced, and a heat dissipation requirement of the intelligent module can be met. In addition, the first plate body may be connected to an appropriate liquid cooling loop to avoid a condensation phenomenon of the intelligent module when the liquid cooling heat dissipation mode is used for the intelligent module, so that a short circuit caused by the condensation phenomenon of the intelligent module can be avoided, and safety of heat dissipation of the intelligent module can be improved.

## Description

### TECHNICAL FIELD

This application relates to the field of vehicle technologies, and in particular, to a heat dissipation apparatus, a vehicle, and a heat dissipation control method.

### BACKGROUND

With an increasingly high level of autonomous driving, computing power and power consumption of a system-on-chip (system-on-chip, SoC) on a vehicle-mounted intelligent module are increasingly high, and a heat dissipation requirement of the intelligent module is also increasingly high. Currently, a natural heat dissipation mode or an air cooling heat dissipation mode is usually used for a vehicle-mounted intelligent module. However, heat dissipation capabilities of the two heat dissipation modes are limited, heat dissipation effects are not ideal enough, and it is difficult to meet a heat dissipation requirement of the intelligent module.

### SUMMARY

This application provides a heat dissipation apparatus, a vehicle, and a heat dissipation control method, to improve a heat dissipation capability and meet a heat dissipation requirement of an intelligent module.

According to a first aspect, this application provides a heat dissipation apparatus, where the heat dissipation apparatus may include a housing and an air cooling part. The housing may include a first plate body, and an intelligent module close to the first plate body may be disposed in the housing. The air cooling part and the intelligent module may be disposed on a same side of the first plate body. The first plate body may have a first cavity inside, the first plate body may be located in a plurality of liquid cooling loops, the first plate body may be selectively connected to one of the plurality of liquid cooling loops, and the air cooling part and/or the first plate body may dissipate heat for the intelligent module.

In the technical solution provided in this application, the heat dissipation apparatus includes both the air cooling part and the plurality of liquid cooling loops. When a temperature of a liquid cooling loop in the plurality of liquid cooling loops meets a connection condition, the first plate body may be connected to the liquid cooling loop. The heat dissipation apparatus may use a liquid cooling heat dissipation mode, an air cooling heat dissipation mode, or a heat dissipation mode combining air cooling and liquid cooling for the intelligent module. When temperatures of all the liquid cooling loops do not meet a connection condition, the first plate body is not connected to any liquid cooling loop, and the heat dissipation apparatus may use the air cooling heat dissipation mode for the intelligent module. The heat dissipation apparatus may dissipate heat for the intelligent module in the liquid cooling heat dissipation mode or the heat dissipation mode combining air cooling and liquid cooling, and has a strong heat dissipation capability. Therefore, a heat dissipation effect on the intelligent module can be enhanced, and a heat dissipation requirement of the intelligent module can be met. In addition, in this application, an appropriate connection condition may be configured to avoid a condensation phenomenon of the intelligent module when the heat dissipation apparatus uses the liquid cooling heat dissipation mode for the intelligent module, so that a short circuit caused by the condensation phenomenon of the intelligent module can be avoided, and safety of heat dissipation of the intelligent module can be improved.

In a specific implementation solution, the plurality of liquid cooling loops may include a first liquid cooling loop and a second liquid cooling loop. The first plate body may be connected to the first liquid cooling loop through a first pipe assembly, and the first plate body may be connected to the second liquid cooling loop through a second pipe assembly. The first plate body is connected to different liquid cooling loops through different pipe assemblies, so that connection efficiency can be improved.

When the first pipe assembly is specifically disposed, the first pipe assembly may include a first pipe and a first control valve, and the first control valve is disposed to facilitate control of connection and disconnection of the first pipe. When the second pipe assembly is specifically disposed, the second pipe assembly may include a second pipe and the first control valve, or the second pipe assembly includes a second pipe and a second control valve, and the first control valve or the second control valve is disposed to facilitate control of connection and disconnection of the second pipe.

In a specific implementation solution, a first temperature sensor may be disposed on the first liquid cooling loop, and the first temperature sensor may measure a temperature of the first liquid cooling loop. A second temperature sensor may be disposed on the second liquid cooling loop, and the second temperature sensor may measure a temperature of the second liquid cooling loop.

In a specific implementation solution, the heat dissipation apparatus may further include a temperature and humidity sensor, and the temperature and humidity sensor may measure a temperature and a humidity of an environment in which the intelligent module is located. The temperature and humidity sensor may be electrically connected to the intelligent module. A measurement result of the temperature and humidity sensor may be used to determine a dew point temperature of the environment in which the intelligent module is located, a measurement result of the first temperature sensor, a measurement result of the second temperature sensor, and the dew point temperature may be used to determine a liquid cooling loop connected to the first plate body. Therefore, it can be ensured that the intelligent module does not generate condensation when the liquid cooling loop connected to the first plate body dissipates heat for the intelligent module.

In a specific implementation solution, a first heat conducting part may be disposed on a side that is of the first plate body and that faces the intelligent module, and the intelligent module may be connected to the first heat conducting part. The first heat conducting part is disposed, so that heat dissipation efficiency of the heat dissipation apparatus can be improved.

In a specific implementation solution, the air cooling part may be provided with a heating part, and the heating part may heat an airflow generated by the air cooling part. The heating part is disposed, so that a relative humidity of the environment in which the intelligent module is located can be reduced, and a risk of condensation of the intelligent module can be reduced.

According to a second aspect, this application provides a vehicle, where the vehicle may include a central control system, a battery cooling system, a motor cooling system, and the heat dissipation apparatus according to any implementation solution of the first aspect. The battery cooling system may dissipate heat for a battery of the vehicle, the motor cooling system may dissipate heat for a motor of the vehicle, and the battery cooling system and the motor cooling system may be controlled by the central control system. The first plate body of the heat dissipation apparatus may be located in a plurality of liquid cooling loops, and the plurality of liquid cooling loops may be respectively connected to the battery cooling system and the motor cooling system, so that the heat dissipation apparatus may use a liquid cooling heat dissipation mode for the intelligent module by using the battery cooling system or the motor cooling system.

In a specific implementation solution, the plurality of liquid cooling loops may include a first liquid cooling loop and a second liquid cooling loop, the first liquid cooling loop may be connected to the battery cooling system, and the second liquid cooling loop may be connected to the motor cooling system.

According to a third aspect, this application provides a heat dissipation control method. The method may be applied to the heat dissipation apparatus according to any possible implementation solution of the first aspect or the vehicle according to any possible implementation solution of the second aspect. The method may include:
obtaining a temperature of a first liquid cooling loop and a temperature of a second liquid cooling loop in a plurality of liquid cooling loops; and
determining whether the temperature of the first liquid cooling loop meets a connection condition, and when the temperature of the first liquid cooling loop meets the connection condition, controlling a first plate body of the heat dissipation apparatus to be connected to the first liquid cooling loop, to dissipate heat for an intelligent module;
when the temperature of the first liquid cooling loop does not meet the connection condition, determining whether the temperature of the second liquid cooling loop meets the connection condition, and when the temperature of the second liquid cooling loop meets the connection condition, controlling the first plate body to be connected to the second liquid cooling loop, to dissipate heat for the intelligent module; or
when the temperature of the second liquid cooling loop does not meet the connection condition, skipping connecting the first plate body to the first liquid cooling loop or the second liquid cooling loop, and controlling an air cooling part of the heat dissipation apparatus to be in a working state, to dissipate heat for the intelligent module.

In the technical solution provided in this application, when the temperature of the first liquid cooling loop meets the connection condition, the first plate body of the heat dissipation apparatus may be controlled to be connected to the first liquid cooling loop. In this case, a liquid cooling heat dissipation mode may be used for the intelligent module. When the temperature of the first liquid cooling loop does not meet the connection condition, but the temperature of the second liquid cooling loop meets the connection condition, the first plate body may be controlled to be connected to the second liquid cooling loop. In this case, the liquid cooling heat dissipation mode may also be used for the intelligent module. When the temperature of the second liquid cooling loop does not meet the connection condition either, the first plate body is not connected to any liquid cooling loop. In this case, the air cooling part may be controlled to be in the working state, and an air cooling heat dissipation mode may be used for the intelligent module. The first plate body is controlled to be selectively connected to a liquid cooling loop, so that the liquid cooling heat dissipation mode may be used for the intelligent module, a heat dissipation effect on the intelligent module is ideal, and a heat dissipation requirement of the intelligent module may be met. In addition, an appropriate connection condition may be configured to avoid a condensation phenomenon of the intelligent module when the liquid cooling heat dissipation mode is used for the intelligent module, so that a short circuit caused by the condensation phenomenon of the intelligent module can be avoided, and safety of heat dissipation of the intelligent module can be improved.

In a specific implementation solution, before controlling the first plate body to be connected to the first liquid cooling loop or the second liquid cooling loop, the air cooling part may be controlled to be turned on. When the temperature of the first liquid cooling loop meets the connection condition and the first plate body is connected to the first liquid cooling loop, or when the temperature of the first liquid cooling loop does not meet the connection condition, the temperature of the second liquid cooling loop meets the connection condition, and the first plate body is connected to the second liquid cooling loop, the working state of the air cooling part may not be changed or the air cooling part may not be controlled to be turned off. When the first plate body is not connected to the first liquid cooling loop or the second liquid cooling loop, the air cooling part may be controlled to be turned on, and in this case, the air cooling heat dissipation mode may be used for the intelligent module. When the first plate body is connected to the first liquid cooling loop or the second liquid cooling loop, the working state of the air cooling part may not be changed, and in this case, a heat dissipation mode combining liquid cooling and air cooling may be used for the intelligent module, or the air cooling part may be controlled to be turned off, and in this case, only the liquid cooling heat dissipation mode may be used for the intelligent module. Therefore, at least the air cooling heat dissipation mode may be used for the intelligent module, and heat dissipation of the intelligent module is reliable. In addition, the heat dissipation mode combining liquid cooling and air cooling or the liquid cooling heat dissipation mode may be used for the intelligent module, so that a heat dissipation effect on the intelligent module is ideal. When the heat dissipation effect on the intelligent module is improved with reference to the liquid cooling heat dissipation mode, a condensation phenomenon of the intelligent module can be further avoided, so that a short circuit caused by the condensation phenomenon of the intelligent module can be avoided, and safety of heat dissipation of the intelligent module can be improved. In general, the heat dissipation of the intelligent module can be reliably and safely implemented.

In a specific implementation solution, the controlling an air cooling part of the heat dissipation apparatus to be in a working state includes: when the air cooling part is in the working state, skipping changing the working state of the air cooling part, so that the air cooling part may maintain the working state; or when the air cooling part is in an off state, controlling the air cooling part to be turned on, so that the air cooling part may change from the off state to the working state.

In a specific implementation solution, the connection condition may be: A temperature of a liquid cooling loop is higher than or equal to a sum of a dew point temperature of an environment in which the intelligent module is located and a preset temperature, where a value of the preset temperature is greater than or equal to zero. Therefore, a condensation phenomenon of the intelligent module may be avoided when the liquid cooling heat dissipation mode is used for the intelligent module, so that a short circuit caused by the condensation phenomenon of the intelligent module can be avoided, and safety of heat dissipation of the intelligent module can be improved.

In a specific implementation solution, the heat dissipation control method may further include: obtaining a temperature and a humidity of the environment in which the intelligent module is located, and determining the dew point temperature based on the temperature and the humidity.

According to a fourth aspect, this application provides a heat dissipation control apparatus, where the apparatus includes: a memory, configured to store a computer program; and a processor, configured to execute the computer program stored in the memory, for the apparatus to perform the method in any possible implementation of the third aspect.

According to a fifth aspect, this application provides a computer program product. The computer program product includes computer program code. When the computer program code is run on a computer, the computer is enabled to perform the method according to any possible implementation of the third aspect.

All or a part of the computer program code may be stored in a memory. The memory may be encapsulated together with the processor, or may be independently encapsulated.

According to a sixth aspect, this application provides a computer-readable medium. The computer-readable medium stores instructions, and when the instructions are executed by a processor, the processor is enabled to implement the method according to any possible implementation of the third aspect.

According to a seventh aspect, this application provides a chip. The chip includes a circuit, and the circuit is configured to perform the method according to any possible implementation of the third aspect.

### BRIEF DESCRIPTION OF DRAWINGS

FIG. 1 is a diagram of a structure of a heat dissipation apparatus according to an embodiment of this application;
FIG. 2 is a diagram of a structure of a heat dissipation apparatus according to another embodiment of this application;
FIG. 3 is a diagram of a loop connection of a heat dissipation apparatus according to an embodiment of this application;
FIG. 4 is a diagram of a loop connection of a heat dissipation apparatus according to another embodiment of this application;
FIG. 5 is a diagram of a loop connection of a heat dissipation apparatus according to another embodiment of this application;
FIG. 6 is a diagram of a loop connection of a heat dissipation apparatus according to another embodiment of this application;
FIG. 7 is a diagram of a loop connection of a heat dissipation apparatus according to another embodiment of this application;
FIG. 8 is a diagram of a cooling system of a vehicle according to an embodiment of this application; and
FIG. 9 is a schematic flowchart of a heat dissipation control method according to an embodiment of this application.

Reference numerals:
100: housing; 200: air cooling part; 300: intelligent module; 400: liquid cooling loop; 500: connecting piece;
110: first plate body; 120: first pipe assembly; 130: second pipe assembly; 140: second plate body;
150: third pipe assembly; 310: circuit board; 320: electronic component; 330: connector; 400a: first liquid cooling loop;
400b: second liquid cooling loop; 430: first temperature sensor; 440: second temperature sensor; 111: first cavity;
112: first heat dissipation fin; 113: first heat conducting part; 121: first pipe; 122: first control valve; 131: second pipe;
132: second control valve; 141: second cavity; 142: second heat dissipation fin; 151: third pipe; and 152: third control valve.

### DESCRIPTION OF EMBODIMENTS

The following describes in detail embodiments of this application with reference to accompanying drawings.

For ease of understanding, an application scenario of a heat dissipation apparatus in this application is first described. As a possible application scenario, the heat dissipation apparatus provided in embodiments of this application may be used in the vehicle field, and may dissipate heat for a vehicle-mounted intelligent module (for example, an intelligent driving module, an in-vehicle entertainment module, or a vehicle control module).

The vehicle field is used as an example. With an increasingly high level of autonomous driving, computing power and power consumption of a system-on-chip on a vehicle-mounted intelligent module are increasingly high, and a heat dissipation requirement of the intelligent module is also increasingly high. In a related technology, a natural heat dissipation mode or an air cooling heat dissipation mode is usually used for a vehicle-mounted intelligent module. However, heat dissipation capabilities of the two heat dissipation modes are limited, and it is difficult to meet a heat dissipation requirement of the intelligent module.

In view of this, an embodiment of this application provides a heat dissipation apparatus, to improve a heat dissipation capability and meet a heat dissipation requirement of an intelligent module.

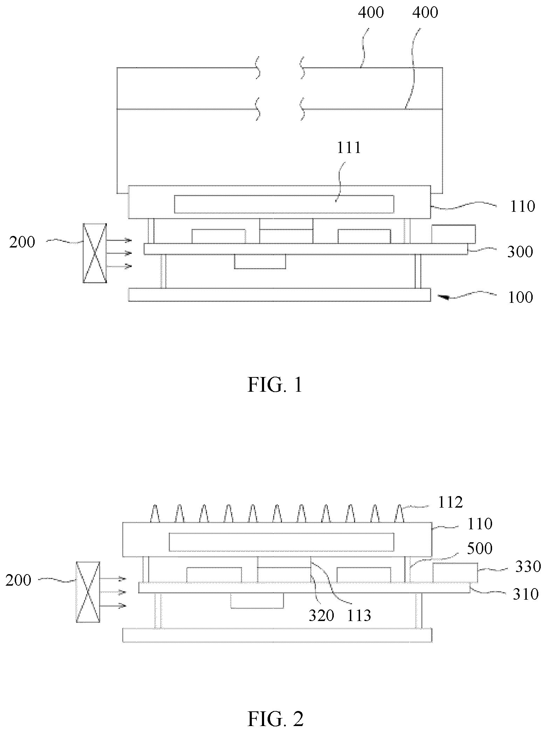

First, refer to FIG. 1. FIG. 1 is a diagram of a structure of a heat dissipation apparatus according to an embodiment of this application. As shown in FIG. 1, the heat dissipation apparatus provided in this embodiment of this application may include a housing 100 and an air cooling part 200. The housing 100 may include a first plate body 110, and an intelligent module 300 close to the first plate body 110 may be disposed in the housing 100. The first plate body 110 may have a first cavity 111 inside, the first plate body 110 may be located in a plurality of liquid cooling loops 400, and the first plate body 110 may be selectively connected to one of the plurality of liquid cooling loops 400. The air cooling part 200 may be disposed inside or outside the housing 100 of the heat dissipation apparatus. Specifically, the air cooling part 200 and the intelligent module 300 may be disposed on a same side of the first plate body 110. The air cooling part 200 and/or the first plate body 110 may dissipate heat for the intelligent module 300.

During an actual application, the heat dissipation apparatus may use an air cooling heat dissipation mode for the intelligent module 300 through the air cooling part 200. When a temperature of a liquid cooling loop 400 in the plurality of liquid cooling loops 400 meets a connection condition, for example, when a temperature of a liquid cooling loop 400 is higher than or equal to a dew point temperature of an environment in which the intelligent module 300 is located, specifically, when a temperature of a coolant in a liquid cooling loop 400 is higher than or equal to the dew point temperature of the environment in which the intelligent module 300 is located, the intelligent module 300 has no condensation risk after the first plate body 110 is connected to the liquid cooling loop 400. In this case, the first plate body 110 may be connected to the liquid cooling loop 400, the first cavity 111 is connected to the liquid cooling loop 400, and the coolant in the liquid cooling loop 400 may flow through the first cavity 111. The heat dissipation apparatus may use a liquid cooling heat dissipation mode, an air cooling heat dissipation mode, or a heat dissipation mode combining air cooling and liquid cooling for the intelligent module 300. When temperatures of all the liquid cooling loops 400 do not meet a connection condition, for example, when the temperatures of all the liquid cooling loops 400 are lower than the dew point temperature of the environment in which the intelligent module 300 is located, specifically, when temperatures of coolants in all the liquid cooling loops 400 are lower than the dew point temperature of the environment in which the intelligent module 300 is located, the intelligent module 300 has a condensation risk after the first plate body 110 is connected to any liquid cooling loop 400. In this case, the first plate body 110 is not connected to any liquid cooling loop 400, and the heat dissipation apparatus may still use the air cooling heat dissipation mode for the intelligent module 300. The heat dissipation apparatus may dissipate heat for the intelligent module 300 in the liquid cooling heat dissipation mode or the heat dissipation mode combining air cooling and liquid cooling, and has a strong heat dissipation capability. Therefore, a heat dissipation effect on the intelligent module 300 can be enhanced, and a heat dissipation requirement of the intelligent module 300 can be met. In addition, an appropriate connection condition may be configured, so that the first plate body 110 can be connected to an appropriate liquid cooling loop 400, to avoid a condensation phenomenon of the intelligent module 300 when the heat dissipation apparatus uses the liquid cooling heat dissipation mode for the intelligent module 300, so that a short circuit caused by the condensation phenomenon of the intelligent module 300 can be avoided, and safety of heat dissipation of the intelligent module 300 can be improved.

Because the heat dissipation apparatus provided in this embodiment of this application can be used to avoid the condensation phenomenon of the intelligent module 300 while dissipating heat for the intelligent module 300, an ingress protection rating (ingress protection rating, IP) of the intelligent module 300 may be a non-IP67 ingress protection rating. For example, the ingress protection rating of the intelligent module 300 may be IP20. In other words, the intelligent module 300 may not need to have a high ingress protection rating, and therefore does not need a process and a component that are required to achieve the high ingress protection rating. For example, the intelligent module 300 does not need to be sealed by applying a waterproof adhesive, and does not need to be provided with a ventilation valve, a reversible moisture absorbing material, or the like. Therefore, costs of the intelligent module 300 can be reduced, and maintainability can be enhanced. A first number in the ingress protection rating indicates a dustproof rating, and a second number indicates a waterproof rating. A larger number indicates a higher ingress protection rating.

Refer to FIG. 2. FIG. 2 is a diagram of a structure of a heat dissipation apparatus according to another embodiment of this application. For reference numerals in FIG. 2, refer to same reference numerals in FIG. 1. As shown in FIG. 2, the intelligent module 300 may include a circuit board 310, and electronic components 320 and connectors 330 that are disposed on the circuit board 310. The circuit board 310 may be fastened to the first plate body 110 through a connecting piece 500, so that the intelligent module 300 is fastened to the first plate body 110. The electronic component 320 may be attached to the first plate body 110. For example, an electronic component 320 with high power consumption in the electronic components 320 may be attached to the first plate body 110, to implement efficient heat dissipation. The intelligent module 300 may be electrically connected to another function module, an electronic component, or the like through the connector 330.

In a specific implementation, the first plate body 110 may be made of a sheet metal material to achieve an ideal heat dissipation effect. The sheet metal material has strong thermal conductivity, light weight, and low costs. The first plate body 110 may alternatively be made of other materials with strong thermal conductivity. A shape of the first plate body 110 may match a shape of the intelligent module 300, to cover the entire intelligent module 300, or cover a main heat-generating part of the intelligent module 300. The shape and a material of the first plate body 110 are not limited in embodiments of this application.

In a possible implementation, a first heat dissipation fin 112 may be disposed on the first plate body 110. For example, the first heat dissipation fin 112 may be disposed on a side that is of the first plate body 110 and that is away from the intelligent module 300. A first heat dissipation boss may be further disposed on the first plate body 110, to improve heat dissipation efficiency. For example, the first heat dissipation boss may be disposed on a side that is of the first plate body 110 and that faces the intelligent module 300. In a specific implementation, the electronic component 320 with high power consumption of the intelligent module 300 may be attached to the first heat dissipation boss.

As a possible implementation, a first heat conducting part 113 may be disposed on the side that is of the first plate body 110 and that faces the intelligent module 300, and the intelligent module 300 may be connected to the first heat conducting part 113, to accelerate heat dissipation of the intelligent module 300. During actual disposing, the electronic component 320 with high power consumption of the intelligent module 300 may be attached to the first heat conducting part 113. The first heat conducting part 113 may be of a sheet-like structure, and a shape of the first heat conducting part 113 may be a plurality of shapes that can cover the electronic component 320 with high power consumption of the intelligent module 300. For example, the shape of the first heat conducting part 113 may be a square, a circle, or the like. The first heat conducting part 113 may be made of a thermal interface material (thermal interface material, TIM) or a metal material with ideal thermal conductivity. A structure and a material of the first heat conducting part 113 are not limited in embodiments of this application.

When both the first heat conducting part 113 and the heat dissipation boss are disposed on the side that is of the first plate body 110 and that faces the intelligent module 300, in a possible specific implementation, the first heat conducting part 113 and a heat dissipation boss may be disposed in a one-to-one correspondence. Specifically, the first heat conducting part 113, the heat dissipation boss, and the first plate body 110 may be disposed in sequence, and the electronic component 320 with high power consumption of the intelligent module 300 may be attached to the first heat conducting part 113. In another possible specific implementation, a part of the first heat conducting parts 113 may be directly disposed on the first plate body 110, and the other part of the first heat conducting parts 113 may be disposed on the heat dissipation boss. A part of electronic components 320 with high power consumption of the intelligent module 300 may be attached to the first heat conducting part 113, and the other part of the electronic components 320 with high power consumption of the intelligent module 300 may be attached to the heat dissipation boss.

As a possible implementation, the air cooling part 200 may be a component that can generate an airflow, for example, a fan. The air cooling part 200 may be electrically connected to the intelligent module 300. The air cooling part 200 may be provided with a heating part, and the heating part may heat an airflow generated by the air cooling part 200, so that a relative humidity of an environment in which the intelligent module 300 is located can be reduced, and a risk of condensation of the intelligent module 300 can be reduced. In a specific implementation, the heating part may be disposed on an airflow flow path of the air cooling part 200. The heating part may be a component that has a heating function and has little impact on flow of the airflow of the air cooling part 200. A specific component used by the heating part is not limited in embodiments of this application.

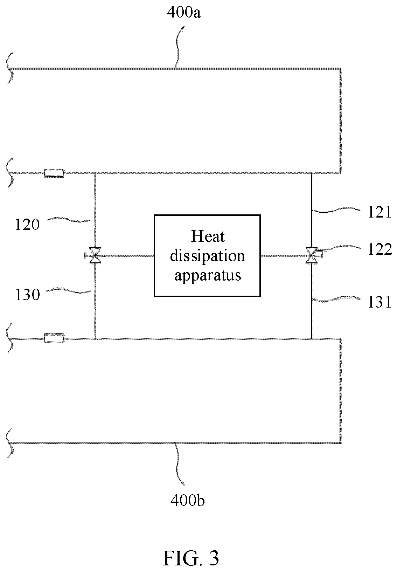

Refer to FIG. 3. FIG. 3 is a diagram of a loop connection of a heat dissipation apparatus according to an embodiment of this application. For reference numerals in FIG. 3, refer to same reference numerals in FIG. 1. As shown in FIG. 3, the plurality of liquid cooling loops 400 may include a first liquid cooling loop 400a and a second liquid cooling loop 400b. The first plate body 110 may be connected to the first liquid cooling loop 400a through a first pipe assembly 120, so that the first cavity 111 may be communicated with the first liquid cooling loop 400a through the first pipe assembly 120. In a specific implementation, the first plate body 110 is connected to the first liquid cooling loop 400a through two first pipe assemblies 120. Similarly, the first plate body 110 may be connected to the second liquid cooling loop 400b through a second pipe assembly 130, so that the first cavity 111 may be communicated with the second liquid cooling loop 400b through the second pipe assembly 130. In a specific implementation, the first plate body 110 is connected to the second liquid cooling loop 400b through two second pipe assemblies 130. In a specific application, the heat dissipation apparatus may freely switch in three working conditions. In one working condition, the first plate body 110 is connected to the first liquid cooling loop 400a, and in this case, the heat dissipation apparatus may use a heat dissipation mode combining liquid cooling and air cooling for the intelligent module 300. In another working condition, the first plate body 110 is connected to the second liquid cooling loop 400b, and in this case, the heat dissipation apparatus may also use the heat dissipation mode combining liquid cooling and air cooling for the intelligent module 300. In another working condition, the first plate body 110 is not connected to any liquid cooling loop, and in this case, the heat dissipation apparatus may still use an air cooling heat dissipation mode for the intelligent module 300.

In a specific implementation, the first pipe assembly 120 may include a first pipe 121 and a first control valve 122, the first pipe 121 may connect the first cavity 111 to the first liquid cooling loop 400a, and connection and disconnection of the first pipe 121 may be controlled by the first control valve 122.

In a specific implementation, the second pipe assembly 130 may include a second pipe 131 and the first control valve 122. The second pipe 131 may connect the first cavity 111 to the second liquid cooling loop 400b, and connection and disconnection of the second pipe 131 may also be controlled by the first control valve 122, that is, connection and disconnection of the second pipe 131 and the first pipe 121 may be controlled by the first control valve 122. For example, the first control valve 122 may be a three-way valve.

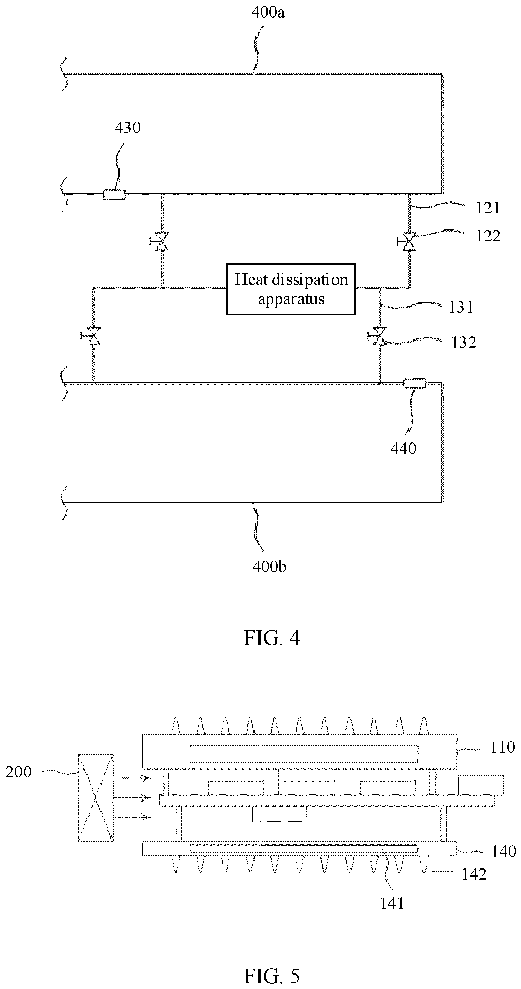

Refer to FIG. 4. FIG. 4 is a diagram of a loop connection of a heat dissipation apparatus according to another embodiment of this application. For reference numerals in FIG. 4, refer to same reference numerals in FIG. 1 and FIG. 3. As shown in FIG. 4, in another specific implementation, the second pipe assembly 130 may include the second pipe 131 and a second control valve 132, the second pipe 131 may connect the first cavity 111 to the second liquid cooling loop 400b, and the connection and disconnection of the second pipe 131 may be controlled by the second control valve 132, that is, the connection and disconnection of the second pipe 131 and the first pipe 121 may be respectively controlled by the second control valve 132 and the first control valve 122. In a specific implementation, the first control valve 122 is in an off state by default, and the second control valve 132 is also in an off state by default.

In a specific implementation, a first temperature sensor 430 may be disposed on the first liquid cooling loop 400a, and the first temperature sensor 430 may measure a temperature of the first liquid cooling loop 400a. Specifically, the first temperature sensor 430 may measure a temperature of a coolant in the first liquid cooling loop 400a. The first temperature sensor 430 may be electrically connected to the intelligent module 300, and the first temperature sensor 430 may report the temperature of the first liquid cooling loop 400a to the intelligent module 300. Similarly, a second temperature sensor 440 may be disposed on the second liquid cooling loop 400b, and the second temperature sensor 440 may measure a temperature of the second liquid cooling loop 400b. Specifically, the second temperature sensor 440 may measure a temperature of a coolant in the second liquid cooling loop 400b. The second temperature sensor 440 may be electrically connected to the intelligent module 300, and the second temperature sensor 440 may report the temperature of the second liquid cooling loop 400b to the intelligent module 300.

As a possible implementation, the heat dissipation apparatus provided in embodiments of this application may further include a temperature and humidity sensor. The temperature and humidity sensor may measure a temperature and a humidity of the environment in which the intelligent module 300 is located. The temperature and humidity sensor may be electrically connected to the intelligent module 300, and the temperature and humidity sensor may report, to the intelligent module 300, the temperature and the humidity of the environment in which the intelligent module 300 is located. The temperature and humidity sensor and the intelligent module 300 may be located on a same side of the first plate body 110. Specifically, the temperature and humidity sensor may be disposed on the circuit board 310 of the intelligent module 300. In an actual application, the intelligent module 300 may determine, based on a measurement result of the temperature and humidity sensor, the dew point temperature of the environment in which the intelligent module 300 is located. The intelligent module 300 may determine, based on a measurement result of the first temperature sensor 430 (namely, the temperature of the first liquid cooling loop 400a), a measurement result of the second temperature sensor 440 (namely, the temperature of the second liquid cooling loop 400b), and the dew point temperature of the environment in which the intelligent module 300 is located, a liquid cooling loop to which the first plate body 110 can be connected, so that after the first plate body 110 is connected to the liquid cooling loop, when the heat dissipation apparatus dissipates heat for the intelligent module 300, the intelligent module 300 does not generate condensation.

Refer to FIG. 5. FIG. 5 is a diagram of a loop connection of a heat dissipation apparatus according to another embodiment of this application. For reference numerals in FIG. 5, refer to same reference numerals in FIG. 1 and FIG. 2. As shown in FIG. 5, the housing 100 may further include a second plate body 140, and the second plate body 140 and the first plate body 110 are disposed at an interval to form accommodation space. The intelligent module 300 may be disposed in the accommodation space between the second plate body 140 and the first plate body 110. Specifically, the circuit board 310 of the intelligent module 300 may be fastened to the first plate body 110 and the second plate body 140 through the connecting piece 500. In an actual implementation, if electronic components 320 with high power consumption are also disposed on a side that is of the circuit board 310 of the intelligent module 300 and that faces the second plate body 140, these electronic components 320 may be attached to the second plate body 140, to improve heat dissipation efficiency.

In a specific implementation, the housing 100 formed by the second plate body 140 and the first plate body 110 may be of a non-closed structure, to dissipate heat for the intelligent module 300 in an air cooling heat dissipation mode. The air cooling part 200 may be disposed in the accommodation space, or may be disposed outside the accommodation space, that is, the air cooling part 200 may be disposed inside the housing 100, or may be disposed outside the housing 100. When the air cooling part 200 is disposed outside the housing 100, the air cooling part 200 may be disposed as close to the housing 100 as possible, so as to be as close to the intelligent module 300 as possible, so that an ideal heat dissipation effect can be ensured when the air cooling heat dissipation mode is used to dissipate heat for the intelligent module 300.

In a specific implementation, the second plate body 140 may be made of a sheet metal material or another material with strong thermal conductivity. A shape of the second plate body 140 may match the shape of the intelligent module 300, to cover the entire intelligent module 300, or cover the main heat-generating part of the intelligent module 300. The shape and a material of second plate body 140 are not limited in embodiments of this application either. A second heat dissipation fin 142 may be disposed on the second plate body 140. For example, the second heat dissipation fin 142 may be disposed on a side that is of the second plate body 140 and that is away from the intelligent module 300. A second heat dissipation boss may be further disposed on the second plate body 140. For example, the second heat dissipation boss may be disposed on the side that is of the second plate body 140 and that faces the intelligent module 300, and an electronic component 320 with high power consumption of the intelligent module 300 may be attached to the second heat dissipation boss.

As a possible implementation, a second heat conducting part may be disposed on the side that is of the second plate body 140 and that faces the intelligent module 300, and the intelligent module 300 may be connected to the second heat conducting part, to further accelerate heat dissipation of the intelligent module 300. During actual disposing, the electronic component 320 with high power consumption of the intelligent module 300 may be attached to the second heat conducting part. A structure and a material of the second heat conducting part are not limited in embodiments of this application either. When both the second heat conducting part and the second heat dissipation boss are disposed on the side that is of the second plate body 140 and that faces the intelligent module 300, in a possible specific implementation, the second heat conducting part and the second heat dissipation boss may be disposed in a one-to-one correspondence. Specifically, the second heat conducting part, the second heat dissipation boss, and the second plate body 140 may be disposed in sequence, and the electronic component 320 with high power consumption of the intelligent module 300 may be attached to the second heat conducting part. In another possible specific implementation, a part of the second heat conducting parts may be directly disposed on the second plate body 140, and the other part of the second heat conducting parts may be disposed on the second heat dissipation boss. A part of the electronic components 320 with high power consumption of the intelligent module 300 may be attached to the second heat conducting part, and the other part of the electronic components 320 with high power consumption of the intelligent module 300 may be attached to the second heat dissipation boss.

As a possible implementation, the second plate body 140 may have a second cavity 141 inside. Similarly, the second plate body 140 may be located in the plurality of liquid cooling loops 400, and the second plate body 140 may be selectively connected to one of the plurality of liquid cooling loops 400.

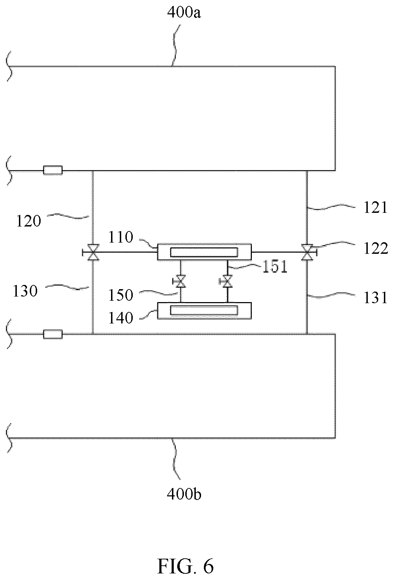

Refer to FIG. 6. FIG. 6 is a diagram of a loop connection of a heat dissipation apparatus according to another embodiment of this application. For reference numerals in FIG. 6, refer to same reference numerals in FIG. 1 and FIG. 5. As shown in FIG. 6, the second plate body 140 and the first plate body 110 may be connected in parallel. In other words, the second cavity 141 and the first cavity 111 may be connected in parallel, and the second plate body 140 and the first plate body 110 may be connected to one liquid cooling loop 400 together. Therefore, the second plate body 140 may also dissipate heat for the intelligent module 300. This improves heat dissipation efficiency of the intelligent module 300.

As a possible implementation, the second plate body 140 may be connected to the first plate body 110 through a third pipe assembly 150, so that the second cavity 141 can be communicated with the first cavity 111 through the third pipe assembly 150, and further communicated with the first liquid cooling loop 400a or the second liquid cooling loop 400b, so that the second plate body 140 and the first plate body 110 are connected in parallel to the first liquid cooling loop 400a or the second liquid cooling loop 400b. In a specific implementation, the second plate body 140 is connected in parallel with the first plate body 110 through two third pipe assemblies 150. The third pipe assembly 150 may include a third pipe 151, and the second cavity 141 may be communicated with the first cavity 111 through the third pipe 151.

When the first pipe assembly 120 includes the first pipe 121 and the first control valve 122, the first control valve 122 may control the connection and disconnection of the first pipe 121. Because the second plate body 140 is connected in parallel with the first plate body 110, the first control valve 122 may also control connection and disconnection of the third pipe 151. It may be understood that the first control valve 122 may control connection and disconnection of the first pipe 121 and the third pipe 151 together, and the first control valve 122 may control whether the coolant in the first liquid cooling loop 400a flows into the first cavity 111 and the second cavity 141.

When the second pipe assembly 130 includes the second pipe 131 and the first control valve 122, the first control valve 122 may control the connection and disconnection of the second pipe 131. Because the second plate body 140 is connected in parallel with the first plate body 110, the first control valve 122 may naturally control the connection and disconnection of the third pipe 151 as well. It may be understood that the first control valve 122 may control connection and disconnection of the second pipe 131 and the third pipe 151 together, and the first control valve 122 may control whether the coolant in the second liquid cooling loop 400b flows into the first cavity 111 and the second cavity 141.

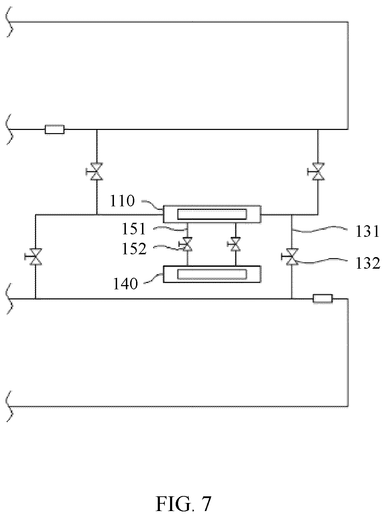

Refer to FIG. 7. FIG. 7 is a diagram of a loop connection of a heat dissipation apparatus according to another embodiment of this application. For reference numerals in FIG. 7, refer to same reference numerals in FIG. 6. As shown in FIG. 7, when the second pipe assembly 130 includes the second pipe 131 and the second control valve 132, the second control valve 132 may control the connection and disconnection of the second pipe 131. Because the second plate body 140 is connected in parallel with the first plate body 110, the second control valve 132 may also control the connection and disconnection of the third pipe 151. It may be understood that the second control valve 132 may control the connection and disconnection of the second pipe 131 and the third pipe 151 together, the second control valve 132 may control whether the coolant in the second liquid cooling loop 400b flows into the first cavity 111 and the second cavity 141.

In a specific implementation, the third pipe assembly 150 may further include a third control valve 152, and the connection and disconnection of the third pipe 151 may be further controlled by the third control valve 152. The third control valve 152 is in an off state by default.

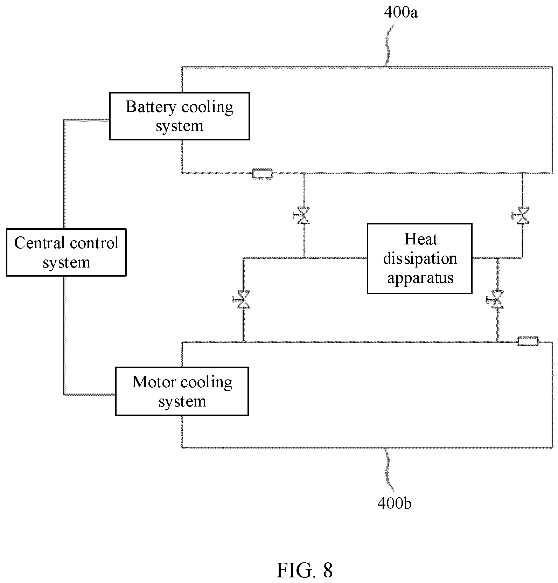

Refer to FIG. 8. FIG. 8 is a diagram of a cooling system of a vehicle according to an embodiment of this application. For reference numerals in FIG. 8, refer to same reference numerals in FIG. 1. An embodiment of this application further provides a vehicle. As shown in FIG. 8, in a possible implementation, the vehicle provided in this embodiment of this application may include a central control system, a battery cooling system, a motor cooling system, and the heat dissipation apparatus described in the foregoing embodiments. The battery cooling system may dissipate heat for a battery of the vehicle. The motor cooling system may dissipate heat for a motor of the vehicle. The battery cooling system and the motor cooling system are controlled by the central control system. The intelligent module 300 may be controlled by the central control system, or the intelligent module 300 may be a part of the central control system.

In a specific implementation, the first plate body 110 of the heat dissipation apparatus may be located in the plurality of liquid cooling loops 400, and the plurality of liquid cooling loops 400 may be respectively connected to the battery cooling system and the motor cooling system. For example, in the plurality of liquid cooling loops 400, the first liquid cooling loop 400a may be connected to the battery cooling system, and the second liquid cooling loop 400b may be connected to the motor cooling system, that is, the heat dissipation apparatus may perform liquid cooling heat dissipation on the intelligent module 300 through the battery cooling system or the motor cooling system. Generally, a temperature of a coolant in the battery cooling system is lower than a temperature of a coolant in the motor cooling system. Therefore, the temperature of the coolant in the first liquid cooling loop 400a is lower than the temperature of the coolant in the second liquid cooling loop 400b.

In a possible use scenario, when the vehicle stops, the intelligent module 300 may be in a sentinel mode. In this mode, the intelligent module 300 may process a vehicle surrounding situation reported by a function module like a sensing module or a monitoring module. In this mode, power consumption of the intelligent module 300 is low. When the intelligent module 300 is in the sentinel mode, only an air cooling heat dissipation mode may be used to dissipate heat for the intelligent module 300. In comparison with a liquid cooling heat dissipation mode, this mode can be used to reduce power consumption of the power battery of the vehicle, support the intelligent module 300 to work for a long time, increase a battery life of the power battery, and avoid a temperature fluctuation of the intelligent module 300 in a large range, to reduce a failure rate of a chip of the intelligent module 300.

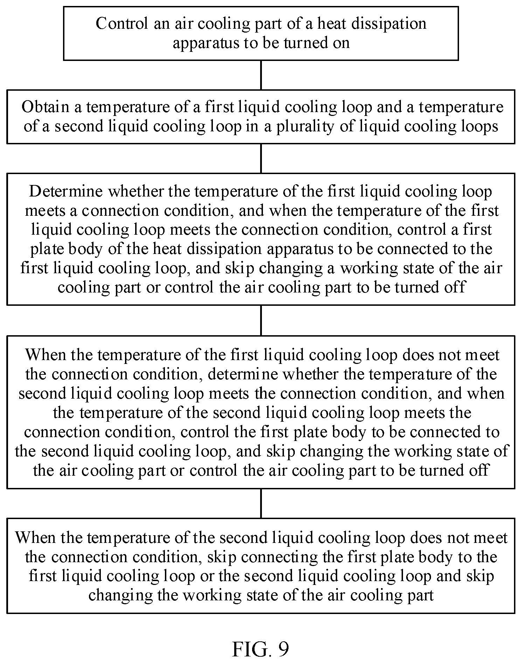

Based on the foregoing heat dissipation control apparatus or vehicle, an embodiment of this application further provides a heat dissipation control method. Refer to FIG. 9. FIG. 9 is a schematic flowchart of a heat dissipation control method according to an embodiment of this application. For reference numerals in FIG. 9, refer to same reference numerals in FIG. 1 and FIG. 4. The heat dissipation control method may include the following steps.

In an initial state, skip connecting the first plate body 110 to the first liquid cooling loop 400a and the second liquid cooling loop 400b.

Obtain a temperature of the first liquid cooling loop 400a and a temperature of the second liquid cooling loop 400b in the plurality of liquid cooling loops 400. Specifically, the temperature of the first liquid cooling loop 400a may be obtained through the first temperature sensor 430, and the temperature of the first liquid cooling loop 400a is reported to the intelligent module 300. The temperature of the second liquid cooling loop 400b may be obtained through the second temperature sensor 440, and the temperature of the second liquid cooling loop 400b is reported to the intelligent module 300.

The intelligent module 300 may determine whether the temperature of the first liquid cooling loop 400a meets a connection condition; and when the temperature of the first liquid cooling loop 400a meets the connection condition, the intelligent module 300 may control the first plate body 110 of the heat dissipation apparatus to be connected to the first liquid cooling loop 400a, or the intelligent module 300 may request a central control system to control the first plate body 110 of the heat dissipation apparatus to be connected to the first liquid cooling loop 400a, so that a liquid cooling heat dissipation mode can be used for the intelligent module 300.

When the temperature of the first liquid cooling loop 400a does not meet the connection condition, the intelligent module 300 may determine whether the temperature of the second liquid cooling loop 400b meets the connection condition; and when the temperature of the second liquid cooling loop 400b meets the connection condition, the intelligent module 300 may control the first plate body 110 to be connected to the second liquid cooling loop 400b, or the intelligent module 300 may request the central control system to control the first plate body 110 to be connected to the second liquid cooling loop 400b, so that the liquid cooling heat dissipation mode can also be used for the intelligent module 300.

When the temperature of the second liquid cooling loop 400b does not meet the connection condition, the first plate body 110 keeps not connected to the first liquid cooling loop 400a and the second liquid cooling loop 400b, and the intelligent module 300 may control the air cooling part 200 of the heat dissipation apparatus to be in a working state, so that an air cooling heat dissipation mode can be used for the intelligent module 300.

According to the heat dissipation control method provided in this embodiment of this application, the first plate body 110 may be controlled to be selectively connected to a liquid cooling loop 400, so that the liquid cooling heat dissipation mode can be used for the intelligent module 300, and a heat dissipation requirement of the intelligent module 300 can be met. In addition, an appropriate connection condition may be configured to avoid a condensation phenomenon of the intelligent module 300 when the liquid cooling heat dissipation mode is used for the intelligent module 300, so that a short circuit caused by the condensation phenomenon of the intelligent module 300 can be avoided, and safety of heat dissipation of the intelligent module 300 can be improved.

As a possible implementation, before the intelligent module 300 controls the first plate body 110 to be connected to the first liquid cooling loop 400a or the second liquid cooling loop 400b, the intelligent module 300 may control the air cooling part 200 to be turned on, so that the air cooling heat dissipation mode can be used for the intelligent module 300. When the intelligent module 300 determines that the temperature of the first liquid cooling loop 400a meets the connection condition, and the intelligent module 300 controls or the intelligent module 300 requests the central control system to control the first plate body 110 to be connected to the first liquid cooling loop 400a, or when the intelligent module 300 determines that the temperature of the first liquid cooling loop 400a does not meet the connection condition, the temperature of the second liquid cooling loop 400b meets the connection condition, and the intelligent module 300 controls or the intelligent module 300 requests the central control system to control the first plate body 110 to be connected to the second liquid cooling loop 400b, the intelligent module 300 does not change the working state of the air cooling part 200, so that a heat dissipation mode combining liquid cooling and air cooling may be used for the intelligent module 300, or the intelligent module 300 controls the air cooling part 200 to be turned off, that is, only the liquid cooling heat dissipation mode can be used for the intelligent module 300.

According to the heat dissipation control method provided in this embodiment of this application, at least the air cooling heat dissipation mode may be used for the intelligent module 300, and heat dissipation of the intelligent module 300 is reliable. In addition, the heat dissipation mode combining liquid cooling and air cooling or the liquid cooling heat dissipation mode may be used for the intelligent module 300, so that a heat dissipation effect on the intelligent module 300 is ideal. When the heat dissipation effect on the intelligent module 300 is improved with reference to the liquid cooling heat dissipation mode, a condensation phenomenon of the intelligent module 300 can be further avoided, so that a short circuit caused by the condensation phenomenon of the intelligent module 300 can be avoided, and safety of heat dissipation of the intelligent module 300 can be improved. Overall, the heat dissipation control method provided in this embodiment of this application can be used to reliably and safely dissipate heat for the intelligent module 300.

In a specific implementation, that the intelligent module 300 controls the air cooling part 200 of the heat dissipation apparatus to be in a working state includes: When the air cooling part 200 is in the working state, the intelligent module 300 does not change the working state of the air cooling part 200, and the air cooling part 200 still maintains the working state; or when the air cooling part 200 is in an off state, the intelligent module 300 controls the air cooling part 200 to be turned on, and the air cooling part 200 changes from the off state to the working state.

In a possible implementation, the connection condition may be: A temperature of a liquid cooling loop 400 is higher than or equal to a sum of a dew point temperature of an environment in which the intelligent module 300 is located and a preset temperature, where a value of the preset temperature is greater than or equal to zero. In a specific implementation, a temperature and a humidity of the environment in which the intelligent module 300 is located may be obtained through a temperature and humidity sensor, and the temperature and the humidity of the environment in which the intelligent module 300 is located are reported to the intelligent module 300. The intelligent module 300 may determine, through calculation or query, the dew point temperature of the environment in which the intelligent module 300 is located based on the temperature and the humidity that are reported by the temperature and humidity sensor.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. A heat dissipation apparatus, comprising a housing and an air cooling part, wherein the housing comprises a first plate body, an intelligent module close to the first plate body is disposed in the housing, and the air cooling part and the intelligent module are disposed on a same side of the first plate body; and
the first plate body has a first cavity inside, the first plate body is located in a plurality of liquid cooling loops, and the air cooling part and/or the first plate body are/is configured to dissipate heat for the intelligent module.

2. The heat dissipation apparatus according to claim 1, wherein the plurality of liquid cooling loops comprise a first liquid cooling loop and a second liquid cooling loop, the first plate body is connected to the first liquid cooling loop through a first pipe assembly, and the first plate body is connected to the second liquid cooling loop through a second pipe assembly.

3. The heat dissipation apparatus according to claim 2, wherein
the first pipe assembly comprises a first pipe and a first control valve; and
the second pipe assembly comprises a second pipe and the first control valve, or the second pipe assembly comprises a second pipe and a second control valve.

4. The heat dissipation apparatus according to claim 3, wherein
a first temperature sensor is disposed on the first liquid cooling loop, and the first temperature sensor is configured to measure a temperature of the first liquid cooling loop; and
a second temperature sensor is disposed on the second liquid cooling loop, and the second temperature sensor is configured to measure a temperature of the second liquid cooling loop.

5. The heat dissipation apparatus according to claim 4, further comprising a temperature and humidity sensor, wherein the temperature and humidity sensor is configured to measure a temperature and a humidity of an environment in which the intelligent module is located, and the temperature and humidity sensor is electrically connected to the intelligent module; and
a measurement result of the temperature and humidity sensor is used to determine a dew point temperature of the environment in which the intelligent module is located, a measurement result of the first temperature sensor, a measurement result of the second temperature sensor, and the dew point temperature are used to determine a liquid cooling loop connected to the first plate body, and the intelligent module does not generate condensation when the liquid cooling loop connected to the first plate body dissipates heat for the intelligent module.

6. The heat dissipation apparatus according to any one of claims 1 to 5, wherein a first heat conducting part is disposed on a side that is of the first plate body and that faces the intelligent module, and the intelligent module is connected to the first heat conducting part.

7. The heat dissipation apparatus according to any one of claims 1 to 6, wherein the air cooling part is provided with a heating part, and the heating part is configured to heat an airflow generated by the air cooling part.

8. A vehicle, comprising a central control system, a battery cooling system, a motor cooling system, and the heat dissipation apparatus according to any one of claims 1 to 7, wherein
the battery cooling system is configured to dissipate heat for a battery of the vehicle, the motor cooling system is configured to dissipate heat for a motor of the vehicle, and the battery cooling system and the motor cooling system are controlled by the central control system; and
the first plate body of the heat dissipation apparatus is located in a plurality of liquid cooling loops, and the plurality of liquid cooling loops are configured to be respectively connected to the battery cooling system and the motor cooling system.

9. The vehicle according to claim 8, wherein the plurality of liquid cooling loops comprise a first liquid cooling loop and a second liquid cooling loop, the first liquid cooling loop is configured to be connected to the battery cooling system, and the second liquid cooling loop is configured to be connected to the motor cooling system.

10. A heat dissipation control method, wherein the method is applied to the heat dissipation apparatus according to any one of claims 1 to 7 or the vehicle according to claim 8 or 9, and the method comprises:
obtaining a temperature of the first liquid cooling loop and a temperature of the second liquid cooling loop in the plurality of liquid cooling loops; and
determining whether the temperature of the first liquid cooling loop meets a connection condition, and when the temperature of the first liquid cooling loop meets the connection condition, controlling the first plate body of the heat dissipation apparatus to be connected to the first liquid cooling loop, to dissipate heat for the intelligent module;
when the temperature of the first liquid cooling loop does not meet the connection condition, determining whether the temperature of the second liquid cooling loop meets the connection condition, and when the temperature of the second liquid cooling loop meets the connection condition, controlling the first plate body to be connected to the second liquid cooling loop, to dissipate heat for the intelligent module; or
when the temperature of the second liquid cooling loop does not meet the connection condition, skipping connecting the first plate body to the first liquid cooling loop or the second liquid cooling loop, and controlling the air cooling part of the heat dissipation apparatus to be in a working state, to dissipate heat for the intelligent module.

11. The heat dissipation control method according to claim 10, wherein
before the first plate body is controlled to be connected to the first liquid cooling loop or the second liquid cooling loop, the air cooling part is controlled to be turned on; and
when the temperature of the first liquid cooling loop meets the connection condition and the first plate body is connected to the first liquid cooling loop, or when the temperature of the first liquid cooling loop does not meet the connection condition, the temperature of the second liquid cooling loop meets the connection condition, and the first plate body is connected to the second liquid cooling loop, the working state of the air cooling part does not change or the air cooling part is controlled to be turned off.

12. The heat dissipation control method according to claim 10, wherein the controlling the air cooling part of the heat dissipation apparatus to be in a working state comprises:
when the air cooling part is in the working state, skipping changing the working state of the air cooling part; or
when the air cooling part is in an off state, controlling the air cooling part to be turned on.

13. The heat dissipation control method according to any one of claims 10 to 12, wherein
the connection condition is: a temperature of a liquid cooling loop is higher than or equal to a sum of a dew point temperature of an environment in which the intelligent module is located and a preset temperature, wherein
a value of the preset temperature is greater than or equal to zero.

14. The heat dissipation control method according to claim 13, wherein the method further comprises:
obtaining a temperature and a humidity of the environment in which the intelligent module is located, and determining the dew point temperature based on the temperature and the humidity.
